(19) **Europäisches Patentamt / European Patent Office / Office européen des brevets**

(11) **EP 1 990 653 B1**

(12) **EUROPEAN PATENT SPECIFICATION**

(45) Date of publication and mention
of the grant of the patent:
**07.11.2018 Bulletin 2018/45**

(51) Int Cl.:
*G01S 7/292* *(2006.01)*   *G01S 7/04* *(2006.01)*
*H03H 17/02* *(2006.01)*

(21) Application number: **08275013.4**

(22) Date of filing: **08.05.2008**

(54) **Signal processing method**

Signalverarbeitungsverfahren

Procédé de traitement des signaux

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **09.05.2007 GB 0708918**

(43) Date of publication of application:
**12.11.2008 Bulletin 2008/46**

(73) Proprietor: **FLIR Systems Trading Belgium BVBA 2321 Meer (BE)**

(72) Inventors:
• **Mullarkey, William J.**
  **Liverpool, Merseyside L20 3BG (GB)**

• **St Hill, Nicholas**
  **Liverpool, Merseyside L20 3BG (GB)**

(74) Representative: **Manley, Nicholas Michael et al WP Thompson**
**8th Floor**
**1 Mann Island**
**Liverpool L3 1BP (GB)**

(56) References cited:
**EP-A2- 0 215 481**      **AU-B2- 760 205**
**US-A1- 2004 090 362**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention, at its most general, is concerned with the processing of a signal to improve resolution of information in the signal and/or to improve signal to noise ratio.

The invention has been developed in connection with radar systems, and has important applications in that field. Nonetheless it should be appreciated that the invention is potentially applicable to processing of signals in many other technical fields. For example it may be used in processing signals representing 2D or 3D images, e.g. from astronomical telescopes.

Prior art document AU 2000 071730 B2 describes a method of improving the determination of a physiological parameter based upon processing measured physiological signals comprising both desired and undesired portions. The signal processing includes techniques such as 'soft' clipping the measured signal to remove the undesired portion.

The aim of a radar system is to allow objects in the surrounding area to be observed, even when they cannot be seen visually, e.g. at night or in fog. An example of an application would be in a marine vessel, where it is desirable for the crew to be able to observe other vessels in the vicinity at all times of day and night to navigate the vessel and avoid collisions.

One example of a conventional radar system uses an antenna rotating about a vertical axis with a period of rotation of typically a small number of seconds. Short pulses of radio (electromagnetic) energy are transmitted periodically as the antenna rotates, with a frequency of typically a few thousand pulses per second. Objects in the line of sight of the transmitted signal may reflect the signal to the same antenna, where they may be received and processed for display on the radar screen. The time between the transmission of the pulse and the reception of a reflection from a particular object gives an indication of the distance of the object from the antenna (the range), while the intensity of the reflected signal gives an indication of the radar cross-sectional area of the object (which is related to its shape, size, and composition). The direction in which the antenna is pointing when a reflection is received gives the bearing or azimuth of the reflecting object with respect to the frame of reference of the radar system.

The reflected signals are initially processed to varying extents before being either displayed for viewing by a human operator or further processed by some automatic observing system. Such initial processing is typically carried out by both analogue electronic circuitry (hardware) and a digital signal processor (hardware and software) and leads to a display of returned signal strength (typically represented by brightness and/or colour) plotted on a screen in polar form against range and azimuth. The display therefore approximates to an aerial view of the region covered by the radar, with reflective objects (or targets) shown by lighted points or areas. The display is typically updated as the antenna rotates, with new information replacing that from the previous sweep (revolution of the antenna).

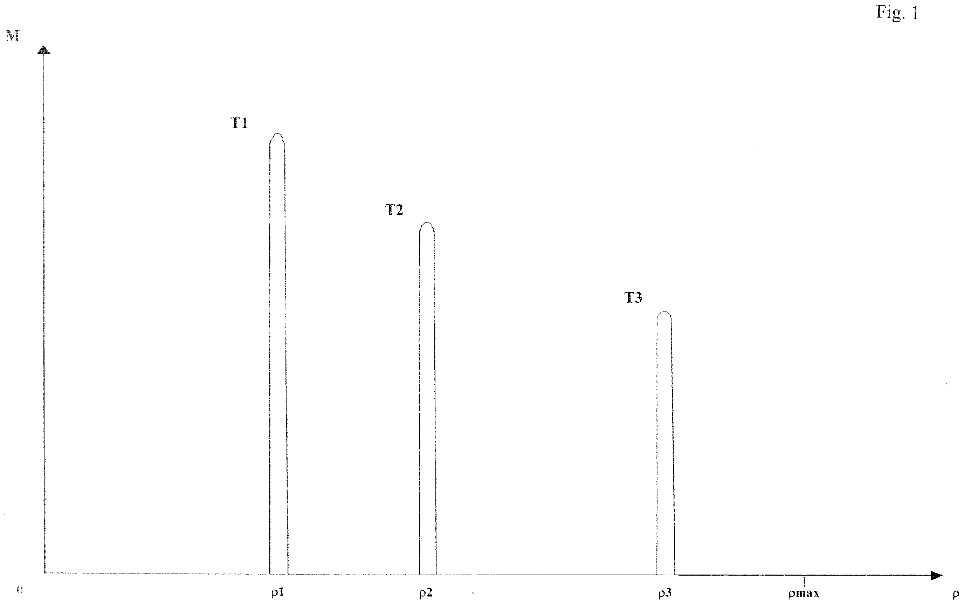

The process described above may be clarified by some diagrams. Figure 1 gives an A-scan plot, which shows the magnitude of the signal received following a single radar pulse, plotted against range (or equivalently, time) with three targets shown. To give an indication of the horizontal scale, a target at a range of 1km will give a reflection at the receiver approximately $6.7\mu s$ after the transmitted radar pulse. The apparent size of a target will depend on its physical size, the duration of the transmitted pulse, and the bandwidth of the receiver. Because the strength of the transmitted (and reflected) radar pulses decays with distance, a given target will return a signal of lower strength at the receiver the further it is from the radar system. For targets having a small angular width, the range law approximates to an inverse fourth-order characteristic of received signal power with range. Typical radar systems will compensate for the lower signals received at greater ranges by applying a time-variable gain (TVG) to the receiver. In that scheme the gain of the receiver increases with time from the initial value it has at the time of each transmitted pulse. Because the returns from targets at greater ranges will arrive later than those from targets at lesser ranges, the former will be subjected to more gain in the receiver to compensate for their lower strength.

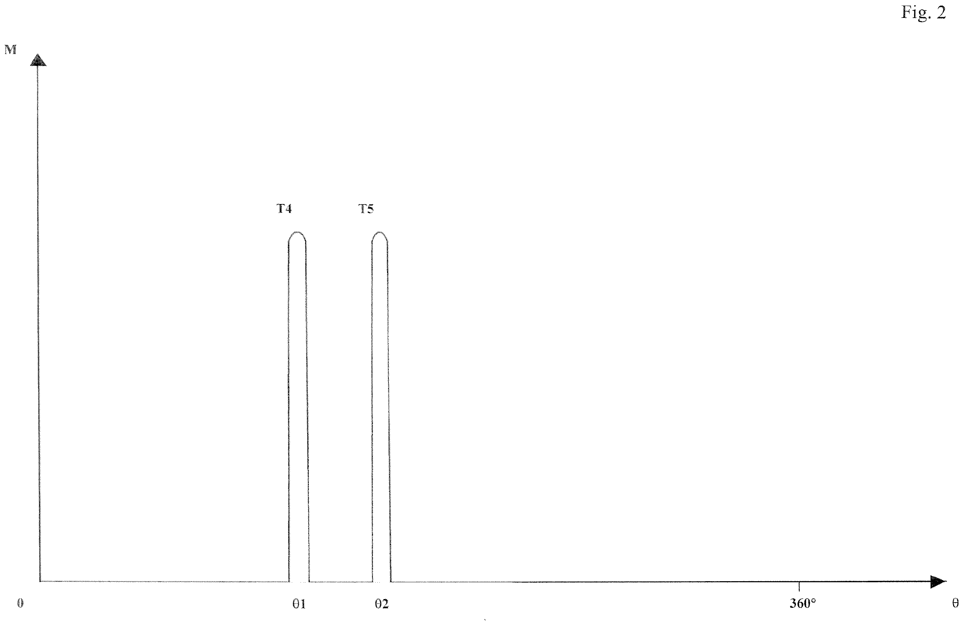

Once the first complete antenna revolution has taken place, the received signal may also be plotted against azimuth (or angle of rotation). Figure 2 gives such a plot, showing the signal amplitude at a single value of range; naturally similar plots could be produced for all values of range. The extent of the horizontal scale can conveniently represent one single antenna revolution, though there is no reason why it should not cover more or less data than this. The scale of the horizontal axis will depend on the antenna's speed of rotation and the axis could typically correspond to a couple of seconds. The apparent size of a target will depend on its physical size, its distance from the radar and the beamwidth (polar response) of the antenna. Unlike in the case of range (shown in the A-scan), there is no intrinsic reason for the signal from a given target to vary with azimuth.

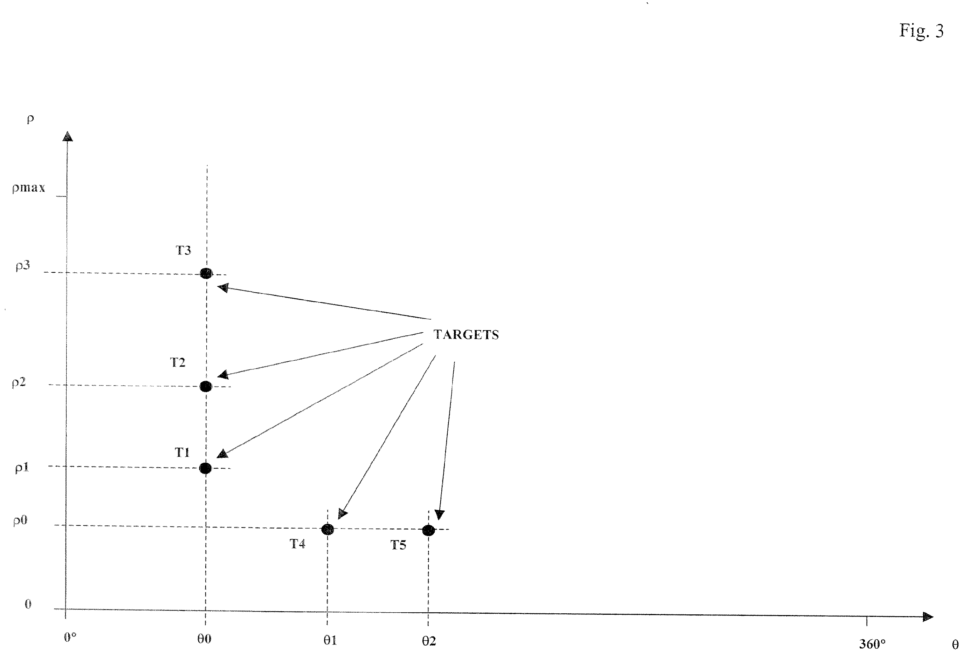

The signals received over a complete antenna revolution may be plotted against both azimuth and range, with the magnitude of the signal represented by colour or brightness. An example of such a plot (known as a B-scan) is given in Figure 3, where the x- and y-axes respectively represent azimuth and range (using scales similar to those in the previous two figures).

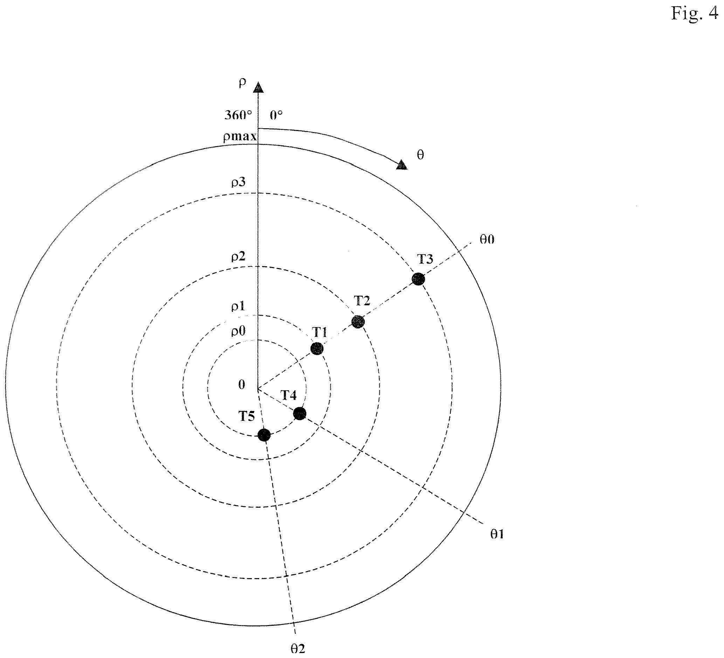

The B-scan is a rectangular surface upon which the dimensions of angular width and range are constant at all points on the surface. This can be converted to a different surface in which the Cartesian dimensions are constant. Such a surface is known as a PPI (Plan Position Indicator) plot, an illustration of which is given in Figure 4. This form of plot is what is typically displayed on the radar screen. The process of converting from the B-scan plot to the PPI is known as coordinate conversion and is well known in the art.

One measure of a radar system's performance is its ability to detect targets in the presence of noise (either arising in the system itself or representing reflections from objects of little or no interest, such as waves on the surface of the sea, which appear as speckle on the radar display screen). A second measure is the ability to resolve targets that are close together, which as far as angular resolution is concerned is largely determined by the beamwidth of the antenna (i.e. how far, in angular terms, the energy in the radar pulses spreads on each side of the direction in which the antenna is pointing). It is desirable to improve the performance of a radar system by increasing its ability to detect targets and/or its ability to resolve targets that are close together.

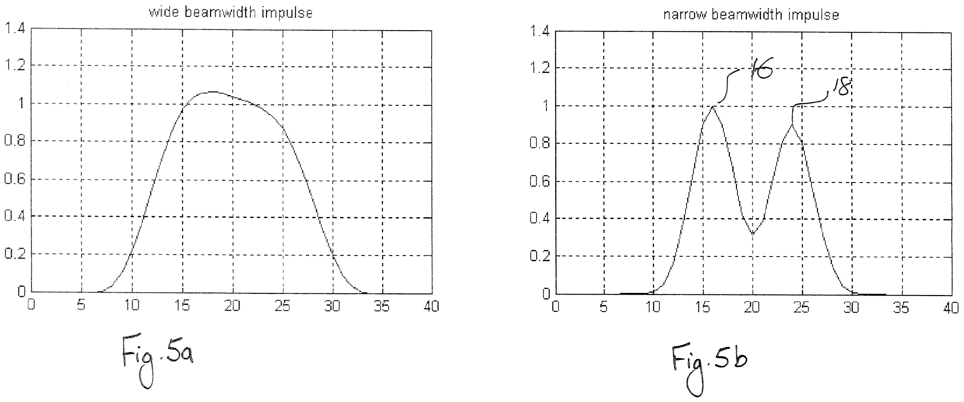

The way in which antenna beamwidth affects the ability to resolve closely spaced targets is illustrated in Figures 5a and b. These may be thought of as expanding on a part of the x-axis of Figure 2 surrounding two closely spaced point-source targets. The plots in Figures 5a and b represent how two point-source targets would be 'seen' by radar systems having antennae with wide and narrow beamwidths, respectively. The two targets are at different azimuths, but are separated by only a small angle. Figure 5a shows how the two targets would be seen by a radar system having a wide beam radar antenna. Note that because of the beamwidth of the antenna the system has failed to resolve the two closely spaced targets. Figure 5b shows how the two targets would be seen by a radar system with an antenna having around half the earlier beamwidth. Consequently two distinct peaks 16 and 18, representing the two targets are now clearly visible.

Clearly radar performance can thus be improved in principle by reducing beamwidth, but such improvements typically require a larger antenna and so increase the cost of the system. Improvements both in resolution and in signal to noise ratio can however be achieved by suitably processing the radar's signal.

A known approach to improving the raw signal-to-noise ratio in a radar is to use some form of filtering. This is typically done by a filter in the receiver, whose bandwidth is matched to the length and shape of the transmitted pulse, together with some form of filtering in azimuth. At its simplest, the latter merely rejects statistically aberrant signals from other radars and integrates the returns from a few consecutive transmitted pulses. When more processing capability is available, some replace the integration-which is a first-order low-pass filter-with a filter matched to the antenna's own frequency response. By their nature, all such filtering techniques lose some of the high spatial frequencies and improve signal-to-noise ratio at the expense of worsening target discrimination.

A known approach to reducing effective beamwidth is to use deconvolution, where the incoming signal is deconvolved in the time domain with the impulse azimuth response of the antenna, effectively to yield a 'perfect' radar. In the frequency domain this may be described as filtering the raw radar returns in azimuth with the inverse filter to that describing the antenna's azimuth response.

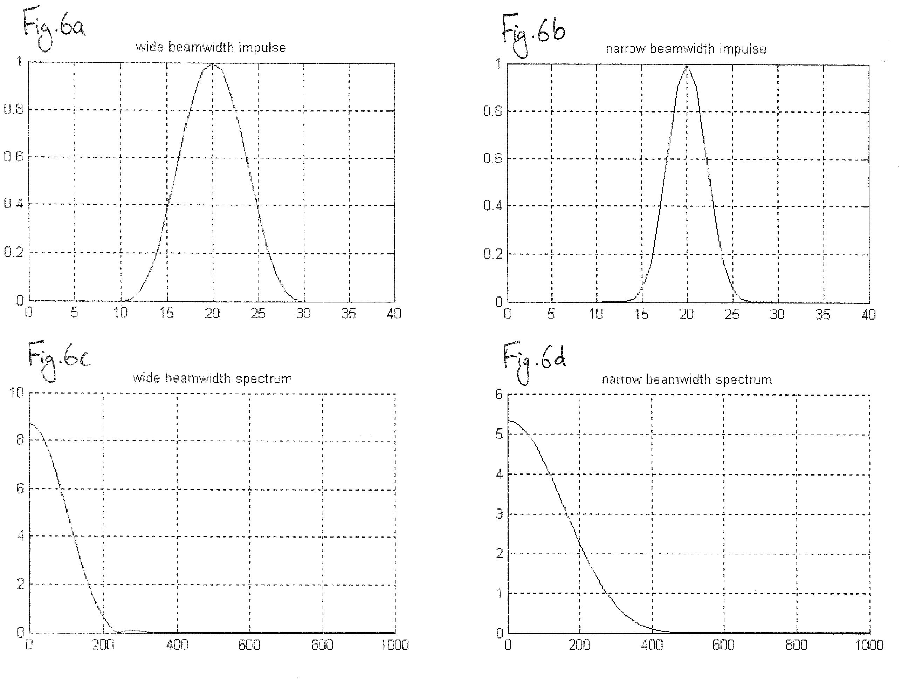

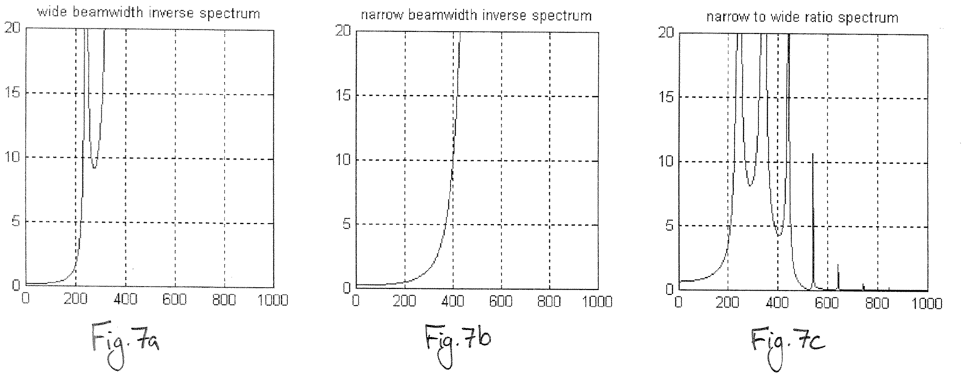

Simplified models of antenna response curves for wide and narrow beam antennae are represented in Figure 6 in the time and frequency domains. Figures 6a and 6b show the impulse response of the wide beam antenna (Fig. 6a) and the narrow beam antenna (Fig. 6b). Figures 6c and 6d show the frequency response of the two antennae, the wide beam antenna response being in Fig. 6c and the narrow beam antenna response in Fig. 6d. It is assumed for the purposes of illustration that the frequency responses are purely real, i.e. have a phase component of zero. Figure 7 shows the spatial frequency responses of corresponding inverse filters, application of which to the radar signal would - an in idealised situation and in the absence of noise - compensate for the antenna's response and provide a true representation of the targets. Figure 7a is the inverse filter for the wide beam antenna, while Figure 7b is that for the narrow beam antenna. Figure 7c will be explained later.

This technique has three main drawbacks. The first is that the filter which describes the antenna's azimuth response is typically a low-pass one, having a low or zero response at high spatial frequencies. The inverse filter will therefore have a high gain at high frequencies, which will result in high-frequency system noise being amplified. In the worst case, the inverse filter may be required to have an infinite response at some high frequencies. The second problem is that the inverse filter may have an impractically long impulse response. Truncating the response can lead to artefacts which may appear as false targets. The third difficulty lies in characterising and tracking the response of the antenna. If this is not done correctly, as a result for example of manufacturing and operational variations, the resulting supposedly inverse filter will no longer match the antenna's response and may generate spurious apparent radar echoes. In practice, one might not be so ambitious but might be satisfied with trying to achieve the resolution of a better radar, i.e. one with a narrower antenna beamwidth, rather then a perfect one. In this case, the filter applied would have a frequency response given by the ratio of the desired antenna response to that of the actual antenna. This is illustrated in Figure 7c. The difficulties, however, will still remain, albeit to a lesser degree.

In accordance with the present invention, there is a signal processing method comprising:

(a) establishing an initial baseline level for clipping on the basis of a signal obtained while the radar system is not transmitting, and subsequently adjusting the baseline level for clipping on the basis of a signal obtained in operation of the radar;

(b) subtracting the baseline level for clipping from a digital input signal;

(c) applying a digital finite impulse response filter to the digital input signal; and

(d) clipping the filtered signal to raise values of the filtered signal that are below the baseline level for clipping to the baseline level for clipping;

wherein the steps c and d are carried out repeatedly and iteratively, with the filtered and clipped signal from one iteration of steps c and d forming the input signal of a successive iteration of steps c and d, wherein the steps c and d are carried out for at least two iterations.

Preferably the finite impulse response filter is a low pass filter.

Preferably the finite impulse response filter comprises fewer than fifty coefficients.

Preferably the finite impulse response filter comprises fewer than twenty coefficients.

Preferably the filter comprises fewer than ten coefficients.

Preferably the number of iterations is variable.

Preferably the number of iterations is variable by a user.

Preferably the method further comprises setting a baseline level for clipping with reference to measured signal noise.

Preferably the baseline level for clipping is zero.

Preferably the baseline level for clipping is at or close to a noise level in the signal.

Preferably the method comprises subtracting a chosen offset level from the signal and subsequently clipping to a baseline level of zero.

Preferably the method further comprises pre-filtering the signal prior to iterative steps (c) and (d) to reduce noise.

Preferably the pre-filtering comprises application to the signal of a low pass pre-filter.

Preferably the pre-filtering comprises application to the signal of a wavelet type filter.

Preferably the signal is a radar signal.

Preferably the baseline level is obtained on the basis of a signal obtained while a radar system is not transmitting.

Alternatively the baseline level maybe obtained or adjusted on the basis of a signal obtained while the radar system is transmitting.

Preferably the baseline level for clipping is a function of range.

Preferably the method comprises obtaining mean noise values at a plurality of ranges and obtaining the baseline level for clipping, as a function of range, on the basis of the said mean noise values.

Preferably the method further comprises low-pass filtering the mean noise values to give a smooth curve representing the baseline level for clipping.

Preferably the method comprises establishing an initial baseline level for clipping on the basis of a signal obtained while the radar system is not transmitting, and subsequently adjusting the baseline level for clipping on the basis of a signal obtained in operation of the radar.

Preferably the method further comprises selecting azimuth ranges of low signal amplitude and obtaining the mean values from signal values in the selected azimuth ranges.

Preferably the method comprises obtaining the baseline level for clipping by determining at least one mean signal noise value and a signal noise standard deviation, and adding to the mean value a predetermined multiple of the standard deviation.

Preferably the different filters are applied to the signal during successive iterations.

Preferably the filter used in the iterative process is a finite impulse response filter.

In accordance with a second aspect of the present invention, there is a device for processing a signal, comprising means for:

(a) establishing an initial baseline level for clipping on the basis of a signal obtained while the radar system is not transmitting, and subsequently adjusting the baseline level for clipping on the basis of a signal obtained in operation of the radar;

(b) subtracting the baseline level for clipping level from a digital input signal;

(c) applying a digital finite impulse response filter to the digital input signal;

(d) clipping the filtered signal to raise values of the filtered signal that are below the baseline level for clipping to the baseline level for clipping;

iterating the steps c and d repeatedly for two or more iterations, with the filtered and clipped signal from one iteration of steps c and d forming the input signal of a successive iteration of steps c and d, wherein the steps of c and d are carried out for at least two iterations.

Preferably the finite impulse response filter is a low pass filter.

Preferably the finite impulse response filter comprises fewer than fifty coefficients.

Preferably the finite impulse response filter comprises fewer than twenty coefficients.

Preferably the finite impulse response filter comprises fewer than ten coefficients.

Preferably the device comprises means for varying the number of iterations.

Preferably the number of iterations is variable by a user.

Preferably the device further comprises means for setting the baseline level for clipping with reference to measured signal noise.

Preferably the baseline level for clipping is zero.

Preferably the baseline level for clipping is at or close to a noise level in the signal.

Preferably the clipping comprises raising values in the filtered signal which are below the baseline level to the baseline level.

Preferably the device comprises means for subtracting a chosen offset level from the signal and subsequently clipping to a baseline level of zero.

Preferably the device further comprises a pre-filter applied to the signal prior to iterative steps (c) and (d) to reduce noise.

Preferably the pre-filter comprises a low pass pre-filter.

Preferably the pre-filter comprises a wavelet type filter.

Preferably the device is for processing a radar signal.

Preferably the device comprises means for obtaining the baseline level on the basis of a signal obtained while a radar system is not transmitting.

Preferably the baseline level obtained or adjusted on the basis of a signal obtained while the radar system is transmitting.

Preferably the device comprises means for varying the baseline level for clipping as a function of range.

Preferably the device comprises means for obtaining mean noise values at a plurality of ranges and for obtaining the baseline level for clipping, as a function of range, on the basis of the said mean noise values.

Preferably the device further comprises means for low-pass filtering the mean noise values to give a smooth curve representing the baseline level for clipping.

Preferably the device comprises means for establishing an initial baseline level for clipping on the basis of a signal obtained while the radar system is not transmitting, and for subsequently adjusting the baseline level for clipping on the basis of a signal obtained in operation of the radar.

Preferably the device further comprises means for selecting azimuth ranges of low signal amplitude and obtaining the mean values from signal values in the selected azimuth ranges.

Preferably the device comprises means for obtaining the baseline level for clipping by determining at least one mean signal noise value and a signal noise standard deviation, and adding to the mean value a predetermined multiple of the standard deviation.

Preferably the device is a programmed digital computer.

The device in question is preferably incorporated in a radar system.

The invention may be implemented in a computer program product.

Specific embodiments of the present invention will now be described, by way of example only, with reference to the accompanying drawings, in which:-

Figure 1 is an "A-scan" - a graph of the magnitude of a signal received by a radar system against range (time) for a single emitted pulse at a single azimuth;

Figure 2 is a graph of the magnitude (on the vertical axis) of a signal received by a radar system at a single range against azimuth on the horizontal axis;

Figure 3 is a "B-scan" showing signal magnitude plotted over azimuth (horizontal axis) and range (vertical axis) in Cartesian form;

Figure 4 is a plan position indicator (PPI) plot showing signal magnitude against azimuth and range in polar form;

Figures 5a-b are graphs, each having azimuth on the horizontal axis, used to illustrate the performance of radar systems having wide and narrow beam antennae respectively;

Figures 6a-d are graphs showing responses of antennae with wide and narrow beamwidths in the spatial time domain (impulse response) and frequency domain (spectrum), normalised amplitude being on the vertical axis and time or spatial (angular) frequency as appropriate on the horizontal axis.

Figure 7a-c are graphs showing, in the frequency domain, the responses of two "inverse filters" corresponding respectively to the two antennae of Figure 6, together with the ratio of the two frequency responses;

Figures 8a-8e are a series of graphs, each having signal magnitude on the vertical axis (with the peak values normalised to unity for the purposes of illustration) and azimuth on the horizontal axis, showing in the spatial time domain the results of successive applications of a kernel filter without clipping for the case of a single point-source target, Figures 8f-8j correspond respectively to Figures 8a-8e but represent in the spatial frequency domain the cumulative response of iteratively applying the filter;

Figures 9a and 9b are graphs respectively representing the antenna impulse response before processing and after processing in relation to the image of the same targets seen in Figure 8 (again with the peak values normalised to unity); Figures 9c and 9d respectively represent the spectrum of the antenna before processing and the spectrum achieved with the same antenna after processing of the signal, all for the case of a kernel filter without clipping;

Figures 10a-10e and Figures 10f-10j correspond to Figure 8 but show the results of successive applications of the kernel with clipping after each application;

Figures 11a and 11b are graphs respectively representing the antenna impulse response before processing and after processing in relation to the same targets seen in Figure 10; Figures 11c and 11d respectively represent the spectrum of the antenna before processing and the spectrum achieved with the same antenna after processing of the signal, all for the case of a kernel filter with clipping;

Figures 12a-12e and Figures 12f-12j correspond to Figure 8 but show the results of successive applications of a kernel filter without clipping for the case of two closely spaced point-source targets;

Figures 13a and 13b are graphs respectively representing the antenna impulse response before processing and after processing; Figures 13c and 13d respectively represent the spectrum of the antenna before processing and the spectrum achieved with the same antenna after processing of the signal, all for the case of two closely spaced targets as in Figure 12;

Figures 14a-14e and Figures 14f-14j correspond to Figure 12 but show the results of successive applications of the kernel with clipping after each application;

Figures 15a and 15b are graphs respectively representing the antenna impulse before processing and after processing in relation to the image of the same targets seen in Figure 14; Figures 15c and 15d respectively represent the spectrum of the antenna before processing and the spectrum achieved with the same antenna after processing of the signal, all for the case of two closely spaced targets with clipping as in Figure 14;

Figure 16 is a graph of signal magnitude (vertical axis) against azimuth (horizontal axis) for a radar system, in which the signal includes noise and a 'clipping level' is shown;

Figure 17 is a polar plot showing 'quiet' regions in a radar's field of view; and Figure 18 is a graph of signal magnitude (vertical axis) against range (horizontal axis) in which the signal includes noise and the variation of a chosen clipping level with range is indicated;

Figure 19 is a graph illustrating a vector which has been wavelet transformed; Figure 20 is a graph showing values of the coefficients for a specific kernel used in the filter according to the present invention;

Figures 21a and 21b respectively represent the normalised impulse responses of the kernel and the radar and Figures 21c and 21d represent the corresponding spectra;

Figure 22 is a block diagram representing the implementation of the kernel filter.

Figures 23a - 23c respectively are graphs showing the impulse responses of a three-point high-pass filter and a typical low-pass filter, and the convolution of the two. Amplitude is on the vertical axis and time on the horizontal axis. Figures 23d - 23f respectively are graphs showing the corresponding frequency responses of the same high- and low-pass filters, and that of a compound filter consisting of the two cascaded. Amplitude is on the vertical axis and frequency on the horizontal axis.

The method of signal processing to be described below, which embodies the present invention, involves (a) filtering to improve signal to noise ratio and (b) a novel iterative non-linear filtering process.

In the first of these steps, the level of noise in the incoming radar signal is reduced after demodulation by applying both conventional and wavelet filtering matched to the general characteristics of the radar system, including the antenna. The aim of the two filters is to reduce system noise in order to allow the following processing steps to perform more effectively. The aim of wavelet filtering is to give a better improvement in signal-to-noise ratio than is possible with conventional filters without reducing angular resolution.

The conventional filter is a low-pass digital one acting in the azimuth direction of the B-scan, whose cut-off frequency is related to the spatial frequency response of the antenna in use. The primary function of this filter is to reduce noise introduced by the fact that the sampling process applied to the received signal data may not be synchronised with the transmitted radar pulses, so introducing some timing jitter, and that the reality which the radar observes is certainly not synchronised with that process. An improvement would be to perform this filtering in two dimensions (range and azimuth) and this may be done in other embodiments of the invention although this would require additional processing time.

Since the antenna, when viewed as a filter as illustrated in Figure 6, typically has a low-pass spatial frequency response, any components present in the stop band of the antenna can only result from system noise introduced by the radar's receiver. It is this high-frequency system noise which is also reduced or eliminated by the filtering process.

The wavelet filter acts in the azimuth direction. A property of the wavelet transform is that it decomposes an input signal into components having different scales, in much the same way as the Fourier transform decomposes a signal into different frequency components. The basis function for the wavelet transform is selected to represent a reasonably good match to the spatial impulse response (i.e. the polar response or beamwidth characteristic) of typical radar antennas. Desired radar returns will therefore be accurately represented by few components, which will contain the bulk of the signal energy. In the present embodiment, the remaining, lower energy, components are then attenuated to reduce the level of unwanted noise.

To perform the wavelet filtering a vector (of length N) is transformed using a suitable basis function. The vector to be transformed (the input vector) is the incoming signal from the radar, and could be all of the samples around one revolution of the radar antenna at a single value of range or, more probably, the samples in a small sector of a revolution.

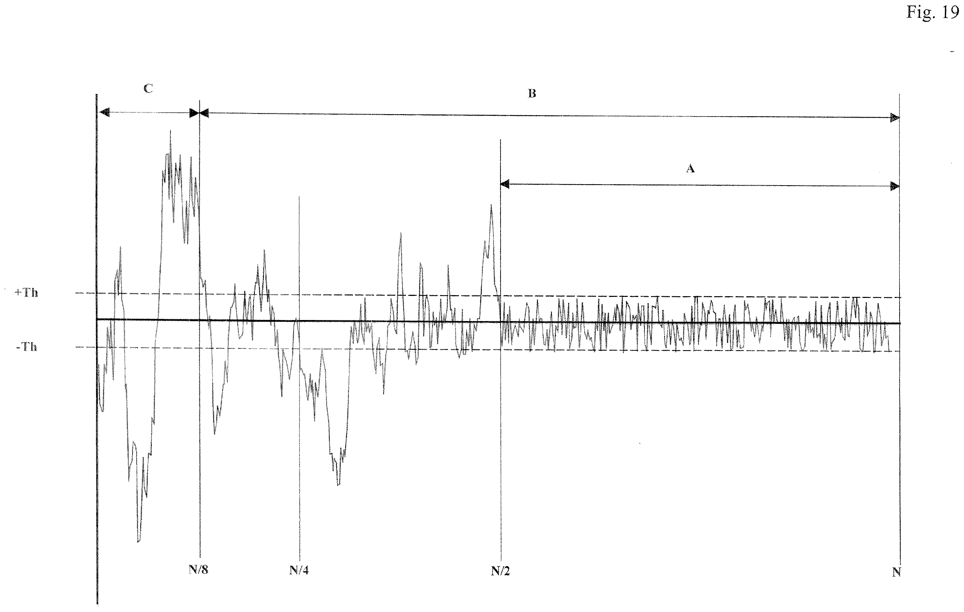

The graph of Figure 19 shows the amplitudes of the components of the signal derived by the transformation, plotted against the position of each component in the input signal. The horizontal axis is divided into regions corresponding to components at different scales (different levels of detail in the input signal). The regions are separated by the discontinuities at the points $N/2$, $N/4$ and $N/8$ (and so on) which correspond to changes in scale (by a factor of two each time). Each region shows the components at the corresponding scale for the entire input vector. As we move to larger scale components (towards the left of the graph), the input signal is effectively subsampled by increasing powers of two, which explains why fewer points are needed on the horizontal axis to show the amplitudes of those components. Thus the range $N/2$ to $N$ (Region A) represents the finest scale (most detailed) components in the entire input vector, the range from $N/4$ to $N/2$ represents the next finest scale components in the entire input vector, and so forth.

The components present in Region A may be assumed to be predominantly due to the noise present in the signal (and particularly the finest scale components of the noise) because any radar returns received via the antenna should have no components present at this fine scale. A threshold may be derived from the components in Region A by, for example, taking their root mean square value. If any part of the transformed signal contained in Region B lies below this threshold it may be deemed to be a noise component and attenuated, either to zero or to a small residual level. The components in Region C are assumed to have arisen from signals received by the radar's antenna and are not attenuated. (Please note that the threshold referred to here is not the same as the clipping threshold referred to in the following text in connection with the main iterative algorithm.)

In the second of the steps referred to above, the signal is passed, after the wavelet filter, to a novel iterative non-linear filtering process. In this process the signal is first filtered by a finite impulse response filter having only a few coefficients (the 'kernel') and acting in the azimuth direction in the B-scan. In this embodiment the only positive coefficients present in the kernel occur at or near its centre, which means that any artifacts that might be introduced because of its short length are negative ones. Other forms of kernel may nonetheless be used in other embodiments. After filtering using the kernel, these negative artifacts are clipped at a baseline level. The filtering and clipping steps are repeated either for a fixed number of iterations or until the desired degree of improvement is achieved.

A classical approach to enhancement of radar signals aims to reverse the effect of poor azimuthal resolution due to a wide beamwidth impulse response from the antenna. It does this by applying a filter that attempts to match closely the inverse beamwidth spectrum of the antenna. In the new invention presented here, the kernel is chosen to have generally a low-pass frequency response, to avoid the problem of increased high-frequency noise introduced by adopting the classical approach. Additionally, the kernel is chosen so as to have a frequency response peak where the frequency response of the antenna (treated as a filter) starts to roll off. The effect of the peak is to compensate for the roll-off in frequency response arising from the antenna's non-zero beamwidth, thus leading to an overall response

7

(including that of the antenna) equivalent to that of a radar with a better antenna (i.e. one having a narrower beamwidth).

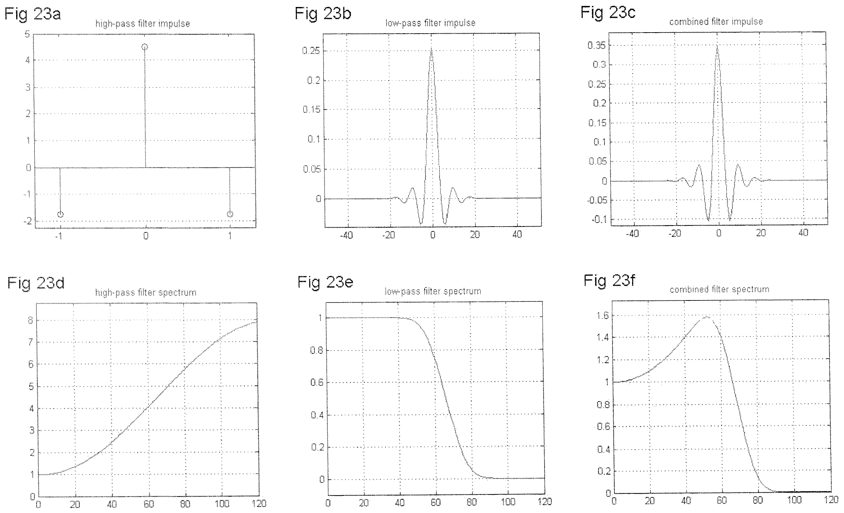

A further way of interpreting the form of the kernel is provided in Figure 23 and will now be elaborated: a three-point filter exemplified in Figure 23a could alone act as kernel and would provide target enhancement by serving as a high-pass filter, as shown in Figure 23d. This would steepen the gradient of the signal from target edges, and would be useful for features that give rise to signals of a narrow azimuthal width. However, applying this filter alone serves to amplify high frequency noise present in the signal. In order to avoid this problem, a low-pass filter is additionally required. Such a filter is exemplified in Figure 23b, which give rise to a frequency response as shown in Figure 23e. The kernel which results from applying both of these high-pass and low-pass filters is a convolution of the two filters. Examples of the resultant impulse and frequency responses from such a kernel are shown in Figures 23c and 23f respectively. An appropriate, mathematically tractable form of such a resultant kernel is given below as a function, $h(\phi)$, containing three adjustable parameters, although other appropriate functions are likely to exist. The desired coefficients may then be obtained by computing the function at the appropriate number of equally spaced discrete spatial values. Typical numbers of computed discrete coefficients are 9, 11, or 15.

A typical kernel would be a finite impulse response digital filter whose coefficients follow the form of a curve defined by the following expression, but are normalised in amplitude to have a sum of unity:

$$h(\phi) = A + B\cos(\phi) + C\cos(2\phi)$$

specified by three parameters $A$, $B$ and $C$, where $\phi$ lies in the range $-\pi$ to $\pi$ radians.

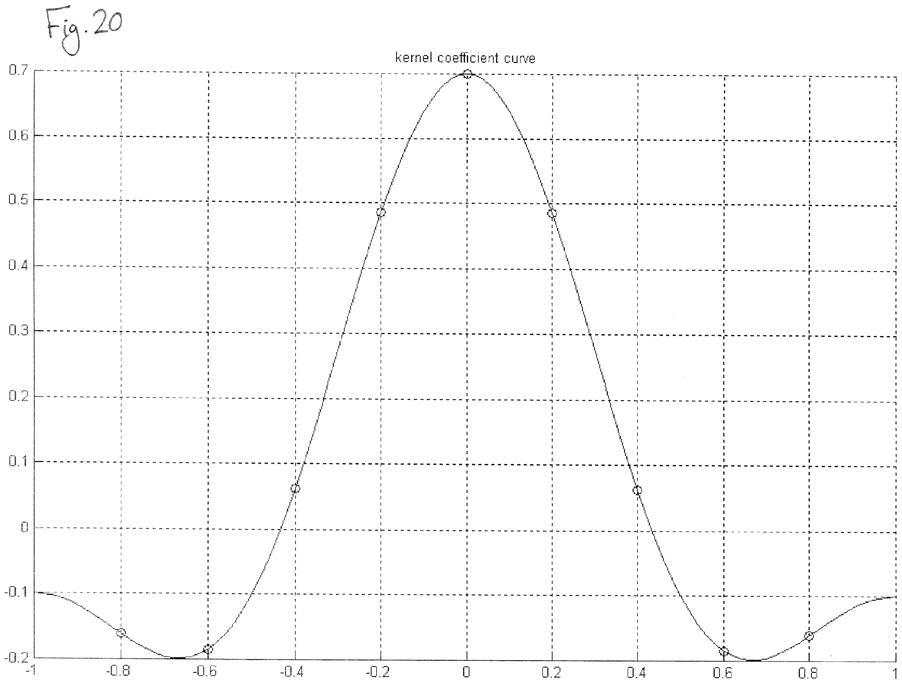

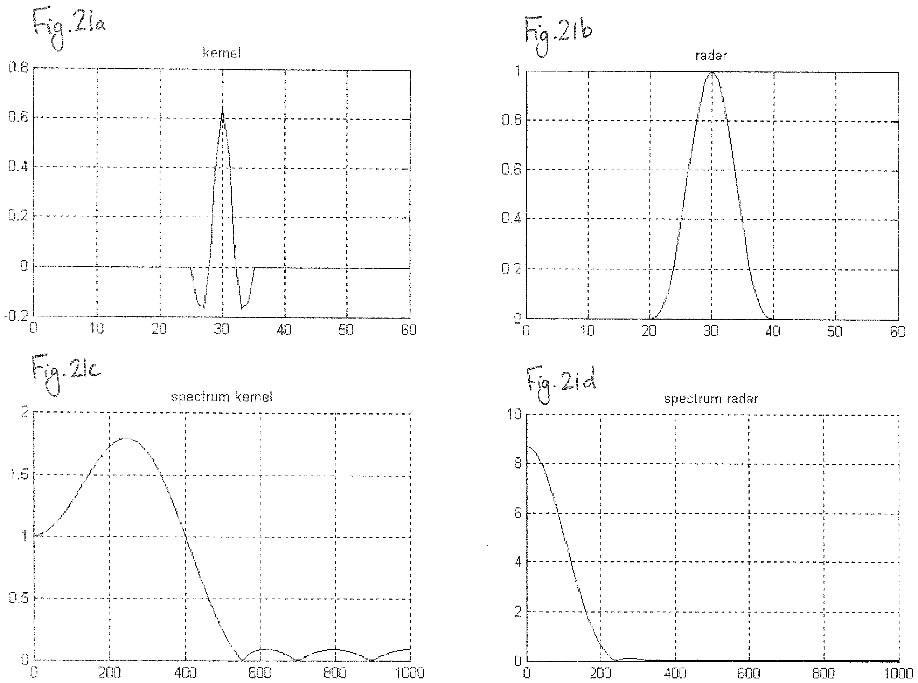

An example of a suitable set of parameters is $A=0.1$, $B=0.4$, $C=0.2$. The resulting curve $h(\phi)$ is then as given in Figure 20, which also shows the unnormalised coefficients of the kernel (in this case nine in number), as small circles on the graph. Because of the nature of finite impulse response filters, these values are the same as the filter's impulse response $f(i)$. The impulse (time) and frequency responses of this filter are given in Figures 21a and 21c, respectively, and the equivalent responses of a mathematical model of an antenna considered as a filter are shown in Figures 21b and 21d.

In the operation of the kernel filter, its coefficients are repeatedly convolved with the most recent samples of the input stream (assuming a finite impulse response filter). This may be represented mathematically as below:

$$y(i) = x(i).h(0) + x(i-1).h(1) + \ldots + x(i-n+1).h(n-1) = \sum_{j=0}^{n-1} x(i-j).h(j) \qquad (1)$$

where $x(i)$ and $y(i)$ are the values of the filter's input and output at sampling instant $i$;

$h(j)$ is the $j$th coefficient of the filter;

$n$ is the order of the filter.

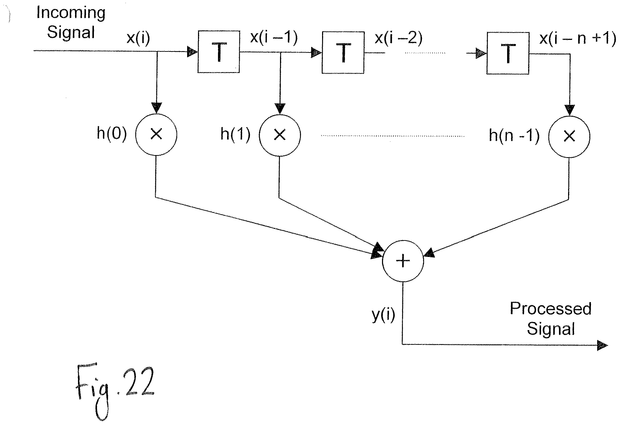

A block diagram illustrating an implementation of the kernel filter is given in Figure 22 which closely follows Equation 1. The blocks marked T each represent a delay of one sample period.

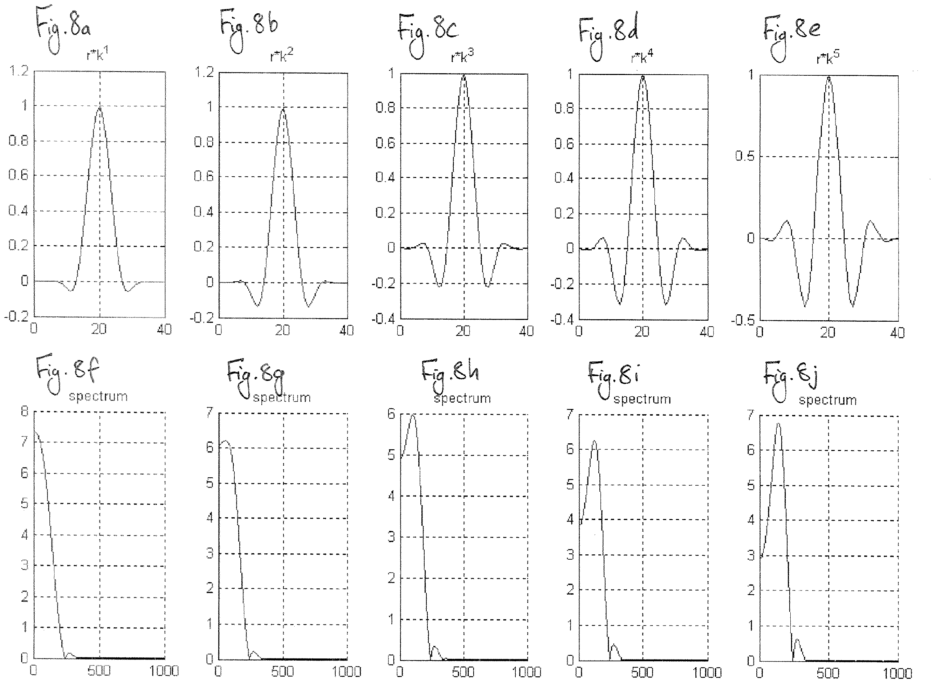

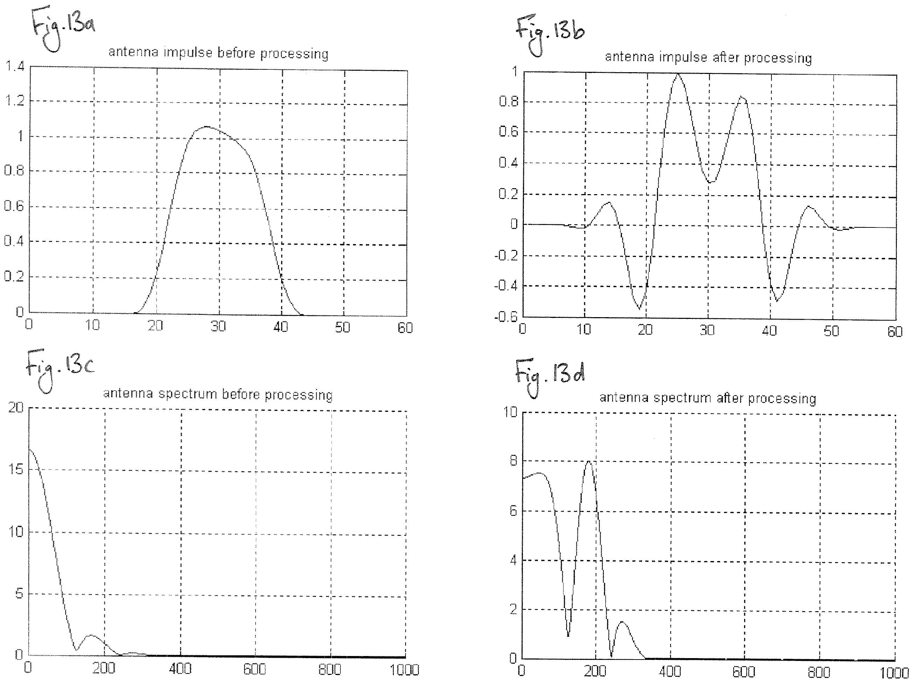

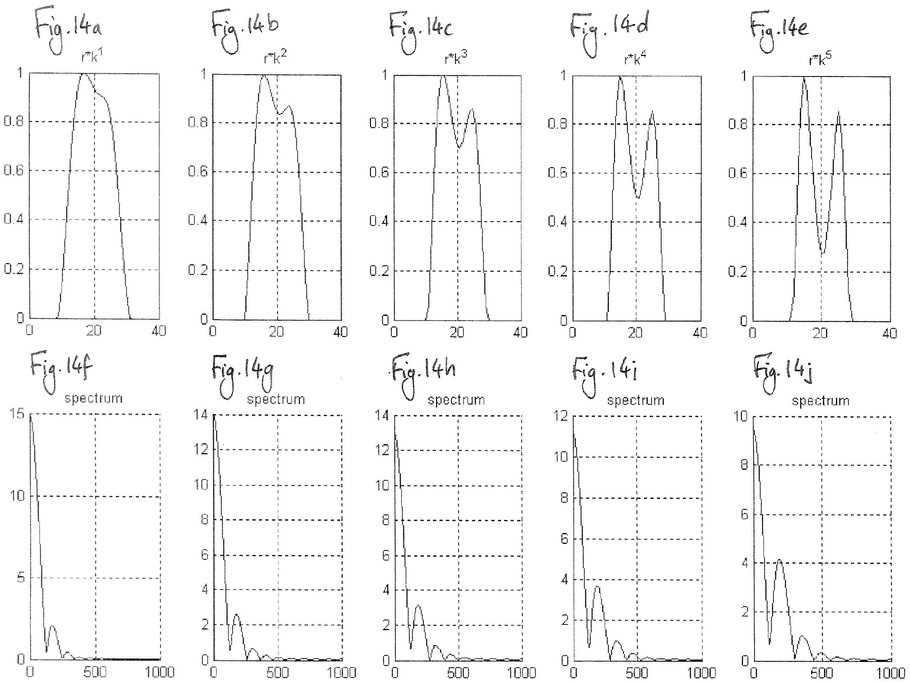

The effect in the spatial (time) domain of filtering using the kernel is to steepen the gradients of features in the radar image in the azimuth direction and so give the effect of an antenna with a narrower beamwidth. This would, for example, tend to separate the returns from closely spaced targets which had merged. An undesirable side effect is to cause ripple (undershoot and/or overshoot) near the baseline at the side of the features, and it is to reduce this ripple that the clipping operation is introduced after each kernel filtering operation. "Clipping" refers to adjusting the value of any signal component which is below the chosen baseline level. Most simply, values below the baseline level may be set to equal the baseline, or to equal some other value. Thus for example the baseline may be at zero signal magnitude, with any negative signal values being adjusted to zero. This is illustrated in Figures 8 to 15 which show the effect in the spatial time domain of iteratively applying the kernel without and with the clipping operation.

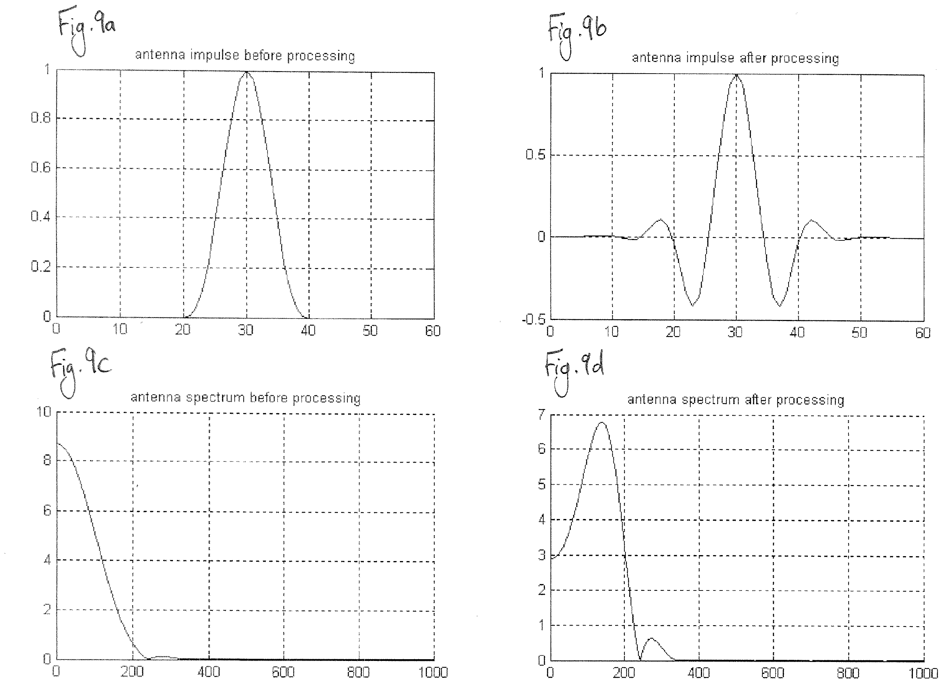

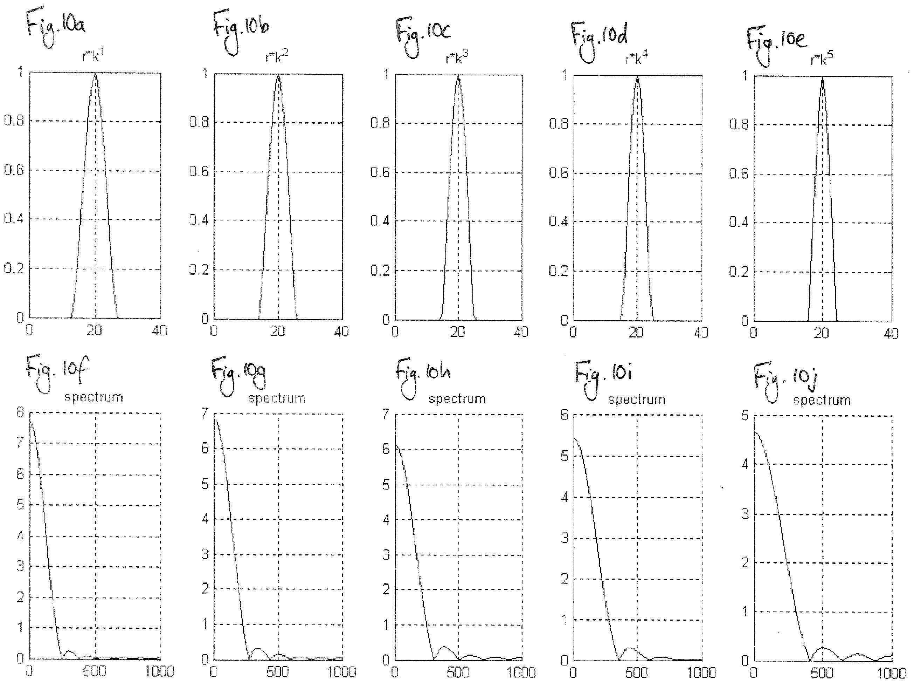

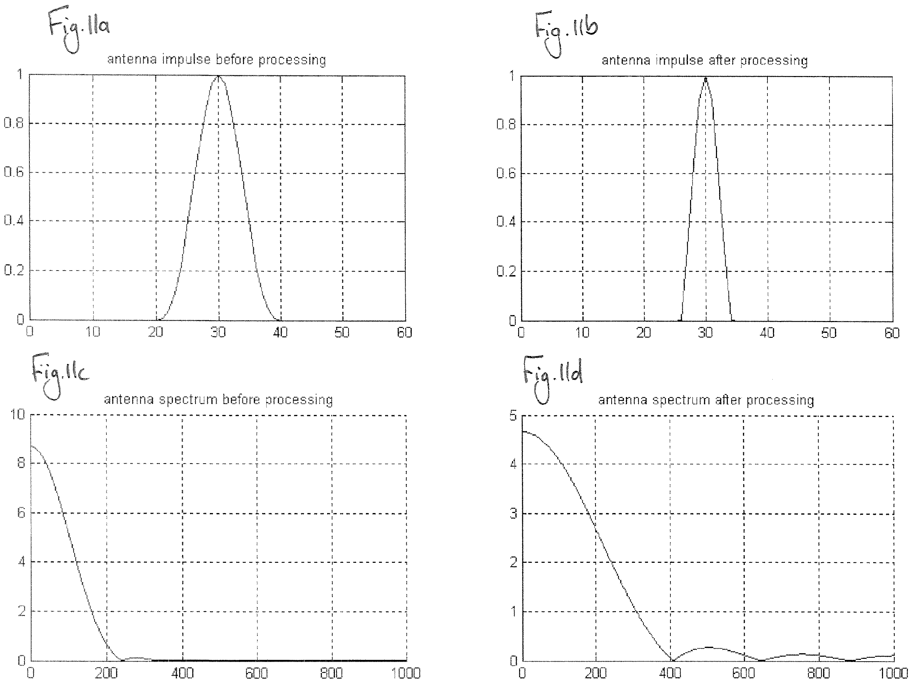

Figures 8a-8j show the effect of repeated filtering using the kernel, without clipping, for the case of a single isolated target. Ripple on either side of the target profile grows upon successive iterations, initially creating meaningless negative values which then lead to erroneous positive signal values on either side of the target. Figure 9 summarises the effect of the process, showing the antenna impulse response and spectrum before processing (Figures 9a and 9c) and after processing (Figures 9b and 9d). Figures 10 and 11 demonstrate that clipping the signal - in this case at zero signal magnitude - prevents this ripple. The effect of the kernel filter itself is seen in the reduced width of the target after several iterations. The corresponding increase in the bandwidth of the signal is evident.

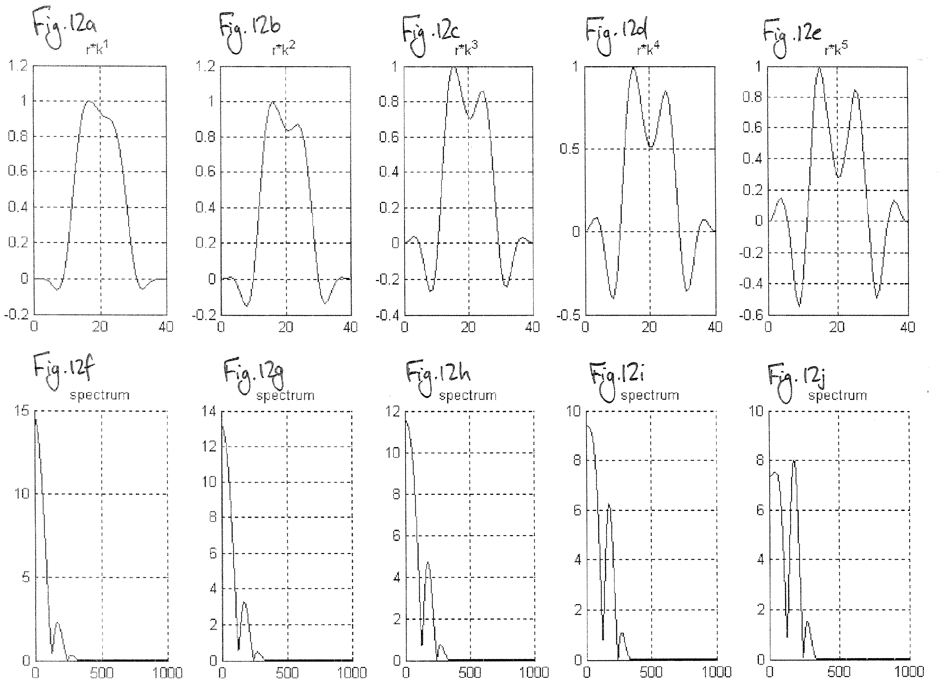

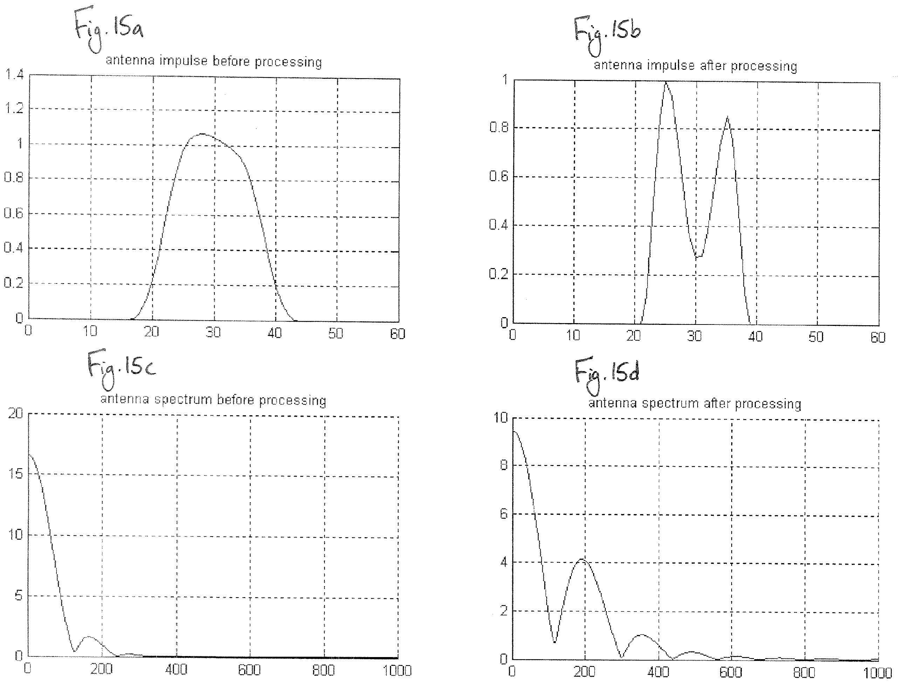

Figures 12 to 15 respectively correspond to Figures 8 to 11 respectively but for the case of two closely spaced targets. It is evident that the two targets, which were merged prior to processing, are now clearly visible as distinct targets. The waveform (impulse response) of the processed signal in Figure 15 may be compared with that of an unprocessed signal from a narrower beam width antenna, as given in Figure 5.

In the example above, the signal is clipped negatively at the zero level. Other clipping levels may, however, be used and various methods may be used to ascertain the appropriate level. If too low a clipping level is used, the sidelobes introduced by the application of the kernel filter may not be prevented; in addition noise may be present in the output signal. If too high a clipping level is used, there is a danger of removing low-amplitude targets.

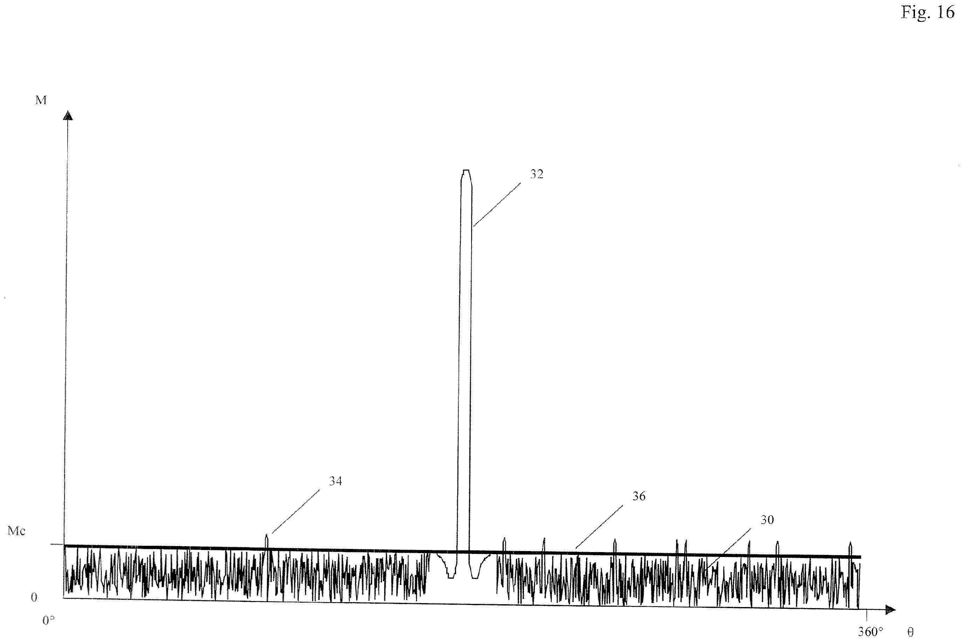

In practice, the signal will typically be superimposed on a residual level of background system noise (also known as instrument noise). In this case the signal may advantageously be clipped at or close to the local background noise level, as shown in Figure 16 in which signal noise can be seen in region 30, a target at 32 and a spike in the noise at 34. The clipping level is indicated by line 36. A major benefit of removing noise in this way is that there are then no high-frequency noise components (possibly at frequencies higher than the original antenna could produce) which would otherwise be emphasised by the kernel filter. The design of the kernel filter therefore becomes less critical, because there are fewer conflicting requirements, and a lower order filter may be used.

The present embodiment uses a means of determining the clipping level which is not dependent on having prior knowledge of the time-variable gain characteristic (if any) that has been used by the radar system. First, the output of the receiver is examined when the radar is in standby mode, i.e. not transmitting. In this mode, the receiver's output will consist primarily of demodulated system noise (assuming that the dominant sources of system noise are before the receiver's demodulator). The amplitude of the noise will have been adjusted by the radar's time-variable gain characteristic and will typically have a rising level with increasing range. Note that the noise is usually positive as a result of the demodulation process, though some components may also be introduced after the demodulator (e.g. analogue-to-digital converter quantisation noise).

To estimate the system noise in standby mode, the system examines the demodulated receiver output for the period of one full antenna revolution, which consists of an array of signal values having indexes in azimuth and range. The individual elements in the array are signal strength values at particular values of azimuth and range.

For each range index, the data at all azimuth indexes are split into a number of sectors, typically 64 in number each containing 32 values. The mean signal value in each sector is calculated and the sectors (typically five in number) having the lowest mean values are identified; these may be called the 'quiet sectors'. An overall mean is then calculated for the quiet sectors by taking the average of the individual means. By considering only the quiet sectors, the effects of any large spurious events are removed. The overall mean values for all ranges are then filtered by a low-pass filter acting in the range direction to give a smooth calibration curve which is stored as a vector and which represents the local mean of the noise, which in turn is taken to represent the time-variable gain characteristic of the receiver.

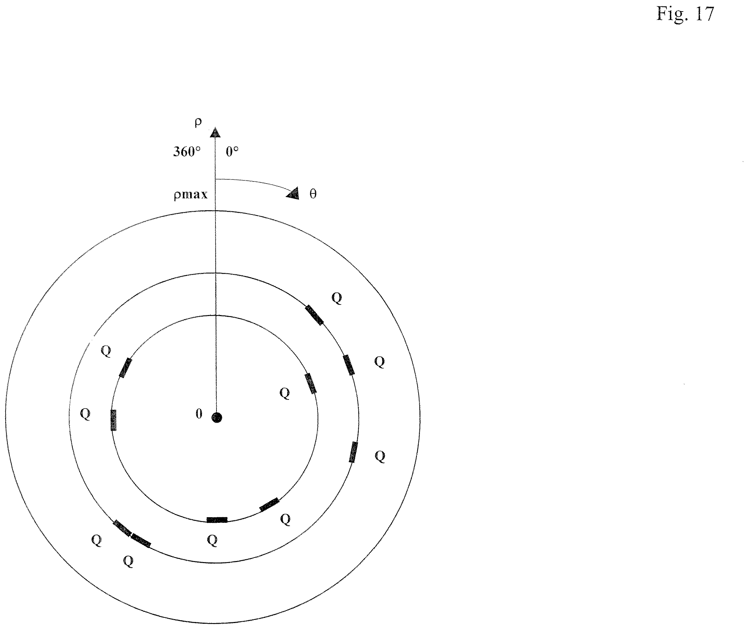

An example of the positions of 'quiet sectors' Q is shown in Figure 17, which is in the form of a PPI plot.

The above procedure yields a calibration curve giving the noise characteristic of the radar system's receiver during standby: that is closely related to its gain characteristic but somewhat different because there will typically be more than one source of the noise. In practice, however, the noise may vary over time during operation. In order to compensate for this, a procedure is used which calculates a correction factor from the output of the receiver while it is in its normal running mode. This may be carried out once for each revolution of the radar's antenna or may be done more or less frequently. In either case, the procedure is similar to that used during standby in that it identifies quiet sectors; in contrast, however, only a sample of ranges (typically three) is used and these are selected to be at longer ranges, where fewer radar returns would be expected (particularly from clutter).

Using the procedure described above, the overall mean signal value is calculated for the ranges selected (three will be used for illustration). These three overall mean values are then each divided by the corresponding values at those three ranges from the gain calibration curve, i.e. they are normalised to the calibration curve. If the noise has not varied since standby, this would be expected to result in three normalised mean values of around unity. The average of these three values is then taken, to give a single gain compensation factor, which may then be applied to the gain calibration curve to give a compensated mean noise curve. This compensated curve may then be used, together with a standard deviation curve calculated as described below, to give the required clipping threshold.

To arrive at a standard deviation curve, the same sample of ranges is used as in obtaining the mean noise values during operation. For each of the quiet sectors at each selected range, the standard deviation of the data in the sector is calculated and averaged over all of the quiet sectors to give an average standard deviation figure for that range. The average standard deviation figure for each of the ranges selected is then normalised by dividing it by the value of the gain calibration curve at that range. The average of the normalised values is then taken, to give an overall estimate of the normalised standard deviation. An estimate of the standard deviation at any particular range may then be obtained by multiplying this single value by the value of the gain calibration curve at that range.

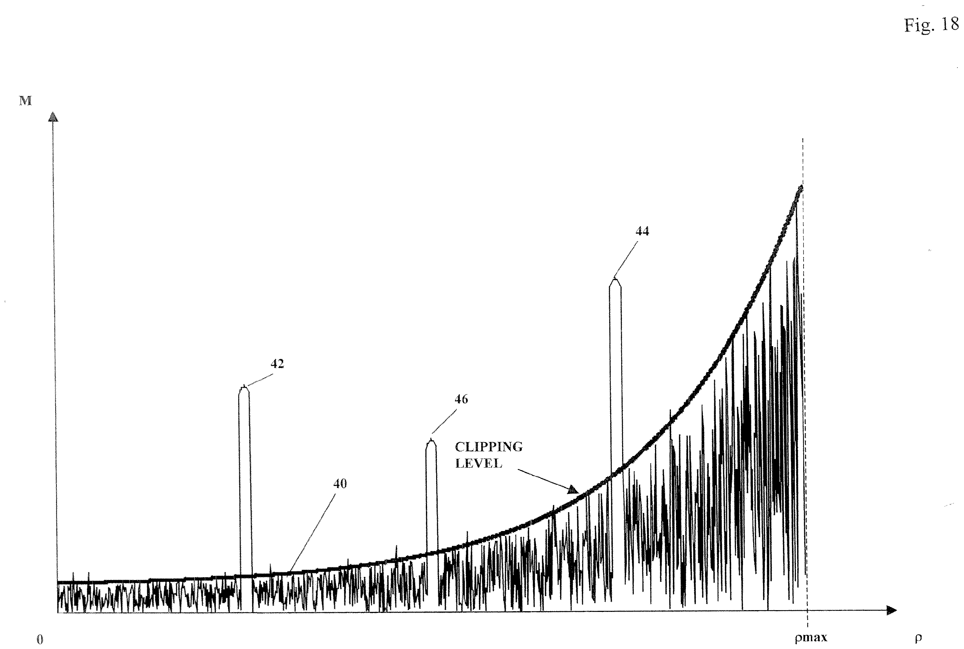

With estimates of the mean and standard deviation of the system noise available for any value of range, the clipping threshold for that range may be determined by taking the mean value plus a multiple (typically three) of the standard deviation value. This results in the removal of most of the system noise, while most targets of significance are left intact, as shown in Figure 18 in which the clipping level, increasing with range, is seen at 40 and targets at various ranges at 42, 44 and 46.

In the current embodiment the required clipping level is subtracted from the signal before the first filtering/clipping iteration is applied and a clipping level of zero is used in subsequent iterations. This has a similar effect to clipping at the required level at each iteration but also removes the background noise level from the output signal.

The above description gives one way of calculating the clipping threshold. Other methods may be used to arrive at the same or a similar effect. For example, the standard deviation could be calculated once during standby and then modified during operation by applying the compensation factor.

A different clipping level could be chosen in a case where a large reflective landmass (such as a beach) is present. In this case, image quality can be improved by clipping at the local minimum value of the signal prior to the iterative process of filtering and clipping. One way to do this is to set the local clipping level of a value under consideration to be the lowest of the nine closest unfiltered values to it in azimuth (at constant range) i.e. the local clipping level is set to be the lowest unfiltered signal value of four adjacent azimuth values on each side of the value under consideration and the value itself. Alternatively, an approximation may be made by calculating the local average and taking a fraction of it as an approximation to the local minimum.

More generally, it should be noted that the clipping level can be locally determined according to the returned signal and can be a function of the local average or the local minimum of the signal. A user control or automated process can serve to alter the clipping level to give different effects on the displayed radar image. Furthermore, the clipping level may be set to a value given by adding a fraction of the local average of the signal to the level determined by considering only the system noise. A user control or automated process can serve to alter the fraction of the local average added according to the nature of the objects present in the radar's field of view.

An advantage of the iterative process according to the present invention is that the use of a filter having only a few coefficients does not require a large amount of computational power. The filtering at each iteration is also fairly gentle in nature. This combined with the use of clipping of the signal results in a robust algorithm which is not strongly tuned to a particular antenna's response and is also fairly insensitive to the number of iterations performed. Indeed the number of iterations lends itself to being controlled by the operator of the radar to give the required degree of signal improvement.

The cumulative effect of several iterations of the filtering/clipping operation is to give a similar effect to the classical approach to beamwidth reduction, but with less processing required and without the need for close matching between the filter and the characteristics of the antenna. Note that it is not necessary for the same filter to be used in each iteration. Instead, two or more different filters could be implemented for use during different iterations. This might for example involve use of a different filter at each iteration.

A composite filter is likely to exist that would have the same overall effect of applying the kernel for a prescribed number of iterations without clipping. However, replacing the iterative process with a single composite kernel is undesirable for three reasons: Firstly, it is desirable to have the number of iterations as a flexible (possibly user-controlled) parameter which may be adapted to the required degree of signal enhancement under a variety of conditions. Secondly, at each iteration, the signal necessarily undergoes the non-linear, signal-dependent action of clipping. This prevents perfect recovery of the original antenna signal by the application of a single composite inverse filter. Thirdly, the filtering/clipping iterative procedure prevents the development of signal artefacts and gives the signal enhancement process a level of mathematical robustness that it would not otherwise possess.

The processing which forms the required algorithm may be performed in software on a digital-signal processor or other processor, or may be implemented in hardware (for example in a gate array).

**Claims**

1. A signal processing method comprising:

   (a) establishing an initial baseline level for clipping on the basis of a signal obtained while the radar system is not transmitting, and subsequently adjusting the baseline level for clipping on the basis of a signal obtained in operation of the radar;
   (b) subtracting the baseline level for clipping from a digital input signal;
   (c) applying a digital finite impulse response filter to the digital input signal; and
   (d) clipping the filtered signal to raise values of the filtered signal that are below the baseline level for clipping to the baseline level for clipping;

   wherein the steps c and d are carried out repeatedly and iteratively, with the filtered and clipped signal from one iteration of steps c and d forming the input signal of a successive iteration of steps c and d, wherein the steps c and d are carried out for at least two iterations.

**2.** A method as claimed in claim 1 in which the finite impulse response filter is a low pass filter.

**3.** A method as claimed in claim 1 in which the signal and its processing are digital and the filter comprises fewer than fifty coefficients.

**4.** A method as claimed in any preceding claim which further comprises pre-filtering the signal to reduce noise prior to iterative performance of steps c and d.

**5.** A method as claimed in claim 4 in which the pre-filtering comprises application to the signal of a wavelet type filter.

**6.** A method as claimed in claim 5 in which the pre-filtering further comprises application of a low pass filter to the signal.

**7.** A method as claimed in any preceding claim in which the signal is a radar signal.

**8.** A method as claimed in any preceding claim in which the baseline level for clipping is at or close to a background signal noise level or is set to zero.

**9.** A device for processing a signal, comprising means for:

(a) establishing an initial baseline level for clipping on the basis of a signal obtained while the radar system is not transmitting, and subsequently adjusting the baseline level for clipping on the basis of a signal obtained in operation of the radar;
(b) subtracting the baseline level for clipping level from a digital input signal;
(c) applying a digital finite impulse response filter to the digital input signal;
(d) clipping the filtered signal to raise values of the filtered signal that are below the baseline level for clipping to the baseline level for clipping;

iterating the steps c and d repeatedly for two or more iterations, with the filtered and clipped signal from one iteration of steps c and d forming the input signal of a successive iteration of steps c and d, wherein the steps of c and d are carried out for at least two iterations.

**10.** A device as claimed in claim 9 in which the finite impulse response filter is a low pass filter.

**11.** A device as claimed in any of claims 9 to 10 which further comprises means for setting the baseline level for clipping with reference to measured signal noise or to a signal level of zero.

**12.** A device as claimed in any of claims 9 to 11 which further comprises a pre-filter applied to the signal prior to iterative steps (c) and (d) to reduce noise.

**13.** A device as claimed in claim 12 in which the pre-filter comprises a wavelet type filter.

**14.** A device as claimed in any of claims 9 to 13 which is for processing a radar signal.

**15.** A computer program product comprising instructions for implementing a method as claimed in any of claims 1-8.

**Patentansprüche**

**1.** Signalverarbeitungsverfahren, das Folgendes beinhaltet:

(a) Festlegen eines anfänglichen Basislinienniveaus für Clipping auf der Basis eines Signals, das erhalten wird, während das Radarsystem nicht sendet, und nachfolgend Justieren des Basislinienniveaus für Clipping auf der Basis eines beim Betrieb des Radars erhaltenen Signals;
(b) Subtrahieren des Basislinienniveaus für Clipping von einem digitalen Eingangssignal;
(c) Anwenden eines digitalen FIR-(Finite Impulse Response)-Filters auf das digitale Eingangssignal; und
(d) Clippen des gefilterten Signals zum Erhöhen von Werten des gefilterten Signals, die unter dem Basislinienniveau für Clipping sind, auf das Basislinienniveau für Clipping;

wobei die Schritte c und d wiederholt und iterativ durchgeführt werden, wobei das gefilterte und geclippte Signal von einer Iteration der Schritte c und d das Eingangssignal einer nachfolgenden Iteration der Schritte c und d bildet, wobei die Schritte c und d für wenigstens zwei Iterationen durchgeführt werden.

2. Verfahren nach Anspruch 1, wobei das FIR-(Finite Impulse Response)-Filter ein Tiefpassfilter ist.

3. Verfahren nach Anspruch 1, bei dem das Signal und seine Verarbeitung digital sind und das Filter weniger als fünfzig Koeffizienten umfasst.

4. Verfahren nach einem vorherigen Anspruch, das ferner das Vorfiltern des Signals beinhaltet, um Rauschen vor einer iterativen Durchführung der Schritte c und d zu reduzieren.

5. Verfahren nach Anspruch 4, bei dem das Vorfiltern das Anwenden eines Filters des Wavelet-Typs auf das Signal beinhaltet.

6. Verfahren nach Anspruch 5, bei dem das Vorfiltern ferner das Anwenden eines Tiefpassfilters auf das Signal beinhaltet.

7. Verfahren nach einem vorherigen Anspruch, bei dem das Signal ein Radarsignal ist.

8. Verfahren nach einem vorherigen Anspruch, bei dem das Basislinienniveau für Clipping an oder nahe dem Hintergrundsignalrauschniveau oder auf null gesetzt ist.

9. Gerät zum Verarbeiten eines Signals, das Mittel umfasst zum:

(a) Festlegen eines anfänglichen Basislinienniveaus für Clipping auf der Basis eines Signals, das erhalten wird, während das Radarsystem nicht sendet, und nachfolgend Justieren des Basislinienniveaus für Clipping auf der Basis eines beim Betrieb des Radars erhaltenen Signals;
(b) Subtrahieren des Basislinienniveaus für Clipping-Niveau von einem digitalen Eingangssignal;
(c) Anwenden eines digitalen FIR-(Finite Impulse Response)-Filters auf das digitale Eingangssignal;
(d) Clippen des gefilterten Signals zum Erhöhen von Werten des gefilterten Signals, die unter dem Basislinienniveau für Clipping liegen, auf das Basislinienniveau für Clipping;

Iterieren der Schritte c und d wiederholt für zwei oder mehr Iterationen, wobei das gefilterte und geclippte Signal von einer Iteration von Schritten c und d das Eingangssignal einer nachfolgenden Iteration der Schritte c und d bildet, wobei die Schritte von c und d für wenigstens zwei Iterationen durchgeführt werden.

10. Gerät nach Anspruch 9, bei dem das FIR-(Finite Impulse Response)-Filter ein Tiefpassfilter ist.

11. Gerät nach einem der Ansprüche 9 bis 10, das ferner Mittel zum Einstellen des Basislinienniveaus für Clipping mit Bezug auf gemessenes Signalrauschen oder auf einen Signalpegel von null umfasst.

12. Gerät nach einem der Ansprüche 9 bis 11, das ferner ein Vorfilter umfasst, das vor iterativen Schritten (c) und (d) zum Reduzieren von Rauschen auf das Signal angewendet wird.

13. Gerät nach Anspruch 12, bei dem das Vorfilter ein Filter des Wavelet-Typs umfasst.

14. Gerät nach einem der Ansprüche 9 bis 13, das zum Verarbeiten eines Radarsignals dient.

15. Computerprogrammprodukt, das Befehle zum Implementieren eines Verfahrens nach einem der Ansprüche 1-8 umfasst.

**Revendications**

1. Procédé de traitement de signal, comprenant les étapes consistant à :

(a) établir un niveau de référence initial d'écrêtage, sur la base d'un signal obtenu pendant que le système radar n'émet pas, puis régler le niveau de référence d'écrêtage sur la base d'un signal obtenu pendant le fonctionnement du radar ;
(b) soustraire le niveau de référence d'écrêtage d'un signal d'entrée numérique ;
(c) appliquer un filtre numérique à réponse impulsionnelle finie au signal d'entrée numérique ; et
(d) écrêter le signal filtré pour augmenter au niveau de référence d'écrêtage des valeurs du signal filtré qui sont inférieures au niveau de référence d'écrêtage ;

les étapes c et d étant réalisées de manière répétée et itérative, le signal filtré et écrêté après une itération des étapes c et d formant le signal d'entrée d'une itération successive des étapes c et d, les étapes c et d étant réalisées pendant au moins deux itérations.

2. Procédé selon la revendication 1, dans lequel le filtre à réponse impulsionnelle finie est un filtre passe-bas.

3. Procédé selon la revendication 1, dans lequel le signal et son traitement sont numériques, et le filtre comprend moins de cinquante coefficients.

4. Procédé selon l'une quelconque des revendications précédentes, comprenant en outre l'étape consistant à préfiltrer le signal pour réduire le bruit avant de réaliser l'itération des étapes c et d.

5. Procédé selon la revendication 4, dans lequel le préfiltrage comprend l'application d'un filtre de type à ondelette au signal.

6. Procédé selon la revendication 5, dans lequel le préfiltrage comprend en outre l'application d'un filtre passe-bas au signal.

7. Procédé selon l'une quelconque des revendications précédentes, dans lequel le signal est un signal de radar.

8. Procédé selon l'une quelconque des revendications précédentes, dans lequel le niveau de référence d'écrêtage est au niveau ou proche d'un niveau de bruit de signal de fond, ou est réglé à zéro.

9. Dispositif de traitement d'un signal, comprenant un moyen permettant de :

(a) établir un niveau de référence initial d'écrêtage, sur la base d'un signal obtenu pendant que le système radar n'émet pas, puis régler le niveau de référence d'écrêtage sur la base d'un signal obtenu pendant le fonctionnement du radar ;
(b) soustraire le niveau de référence d'écrêtage d'un signal d'entrée numérique ;
(c) appliquer un filtre numérique à réponse impulsionnelle finie au signal d'entrée numérique ;
(d) écrêter le signal filtré pour augmenter au niveau de référence d'écrêtage des valeurs du signal filtré qui sont inférieures au niveau de référence d'écrêtage ;

itérer les étapes c et d de manière répétée pendant au moins deux itérations, le signal filtré et écrêté après une itération des étapes c et d formant le signal d'entrée d'une itération successive des étapes c et d, les étapes c et d étant réalisées pendant au moins deux itérations.

10. Dispositif selon la revendication 9, dans lequel le filtre à réponse impulsionnelle finie est un filtre passe-bas.

11. Dispositif selon l'une quelconque des revendications 9 à 10, comprenant en outre un moyen permettant de régler le numéro de référence d'écrêtage en référence à un bruit de signal mesuré ou un niveau de signal égal à zéro.

12. Dispositif selon l'une quelconque des revendications 9 à 11, comprenant en outre un préfiltre appliqué au signal avant l'itération des étapes (c) et (d) pour réduire le bruit.

13. Dispositif selon la revendication 12, dans lequel le préfiltre comprend un filtre de type à ondelette.

14. Dispositif selon l'une quelconque des revendications 9 à 13, destiné au traitement d'un signal de radar.

15. Produit de programme informatique comprenant des instructions permettant de mettre en oeuvre un procédé selon l'une quelconque des revendications 1 à 8.

EP 1 990 653 B1

Fig. 1

M

T1

T2

T3

0          ρ1          ρ2          ρ3          ρmax          ρ

Fig. 2

EP 1 990 653 B1

M

T4    T5

0    θ1    θ2    360°    θ

Fig. 3

EP 1 990 653 B1

Fig. 3

Fig. 4

EP 1 990 653 B1

wide beamwidth impulse

Fig. 5a

narrow beamwidth impulse

Fig. 5b

EP 1 990 653 B1

Fig.6a

wide beamwidth impulse

Fig.6b

narrow beamwidth impulse

Fig.6c

wide beamwidth spectrum

Fig.6d

narrow beamwidth spectrum

EP 1 990 653 B1

wide beamwidth inverse spectrum

Fig. 7a

narrow beamwidth inverse spectrum

Fig. 7b

narrow to wide ratio spectrum

Fig. 7c

Fig.8a — r*k¹

Fig.8b — r*k²

Fig.8c — r*k³

Fig.8d — r*k⁴

Fig.8e — r*k⁵

Fig.8f — spectrum

Fig.8g — spectrum

Fig.8h — spectrum

Fig.8i — spectrum

Fig.8j — spectrum

EP 1 990 653 B1

Fig.9a

antenna impulse before processing

Fig.9b

antenna impulse after processing

Fig.9c

antenna spectrum before processing

Fig.9d

antenna spectrum after processing

Fig. 10a

Fig. 10b

Fig. 10c

Fig. 10d

Fig. 10e

Fig. 10f

Fig. 10g

Fig. 10h

Fig. 10i

Fig. 10j

Fig.11b

antenna impulse after processing

Fig.11d

antenna spectrum after processing

Fig.11a

antenna impulse before processing

Fig.11c

antenna spectrum before processing

Fig.12a
$r*k^1$

Fig.12b
$r*k^2$

Fig.12c
$r*k^3$

Fig.12d
$r*k^4$

Fig.12e
$r*k^5$

Fig.12f
spectrum

Fig.12g
spectrum

Fig.12h
spectrum

Fig.12i
spectrum

Fig.12j
spectrum

Fig.13a

antenna impulse before processing

Fig.13b

antenna impulse after processing

Fig.13c

antenna spectrum before processing

Fig.13d

antenna spectrum after processing

EP 1 990 653 B1

Fig.14a  r*k¹
Fig.14b  r*k²
Fig.14c  r*k³
Fig.14d  r*k⁴
Fig.14e  r*k⁵

Fig.14f  spectrum
Fig.14g  spectrum
Fig.14h  spectrum
Fig.14i  spectrum
Fig.14j  spectrum

EP 1 990 653 B1

Fig. 15a

antenna impulse before processing

Fig. 15b

antenna impulse after processing

Fig. 15c

antenna spectrum before processing

Fig. 15d

antenna spectrum after processing

EP 1 990 653 B1

Fig. 16

EP 1 990 653 B1

Fig. 17

Fig. 18

Fig. 19

Fig. 20

kernel coefficient curve

EP 1 990 653 B1

33

Fig.21a

kernel

Fig.21b

radar

Fig.21c

spectrum kernel

Fig.21d

spectrum radar

EP 1 990 653 B1

Fig.22

Fig 23a — high-pass filter impulse

Fig 23b — low-pass filter impulse

Fig 23c — combined filter impulse

Fig 23d — high-pass filter spectrum

Fig 23e — low-pass filter spectrum

Fig 23f — combined filter spectrum

**REFERENCES CITED IN THE DESCRIPTION**

**Patent documents cited in the description**

*   AU 2000071730 B2